# EUROPEAN PATENT SPECIFICATION

(11) **EP 4 366 482 B1**
(45) Date of publication and mention of the grant of the patent: **11.02.2026**
(21) Application number: 23215653.9
(22) Date of filing: 28.12.2020
(51) Int. Cl.: H01L 23/34, H01L 23/367, H01L 23/473, H01L 25/065, H05K 7/20

(54) **LIQUID COOLING COLD PLATE AND COMMUNICATIONS DEVICE**
FLÜSSIGKEITSGEKÜHLTE KÜHLPLATTE UND KOMMUNIKATIONSVORRICHTUNG
PLAQUE FROIDE DE REFROIDISSEMENT PAR LIQUIDE ET DISPOSITIF DE COMMUNICATION

(30) Priority: 30.04.2020 CN 202010360883
(43) Date of publication of application: 08.05.2024
(62) Divisional of application: 20917272.5
(73) Proprietor: Huawei Digital Power Technologies Co., Ltd., Shenzhen, 518043 (CN)
(72) Inventor: YE, Wen, Shenzhen, 518043 (CN); CHEN, Jun, Shenzhen, 518043 (CN); LI, Quanming, Shenzhen, 518043 (CN)
(74) Representative: Pfenning, Meinig & Partner mbB

(56) References cited:
- EP-A1- 3 531 234
- CN-A- 110 993 576
- CN-U- 205 944 338

## Description

### CROSS-REFERENCE TO RELATED APPLICATIONS

### TECHNICAL FIELD

This application relates to the field of heat dissipation technologies, and in particular, to a liquid cooling cold plate and a communications device.

### BACKGROUND

Currently, a semiconductor component has an increasingly large power density, and there are many heat generating wafers that are concentrated in a neighboring region. Therefore, a liquid cooling cold plate is required to have high heat dissipation efficiency, and can dissipate heat for heat sources that are at different locations and that generate heat differently. A temperature difference between the heat sources also needs to be maintained within a proper range.

When an existing liquid cooling cold plate dissipates heat for a high-power semiconductor component, a fluid channel is not optimized due to a difference between distribution locations and heat losses of wafers. Consequently, there is a large temperature difference between a wafer with a high heat flux density and a wafer with a low heat flux density inside the component, and the wafer with the high heat flux density inside the component may have excessively high temperature, causing an overtemperature risk of the component.

Currently, there are the following two main types of liquid cooling cold plates for a semiconductor: One is a liquid cooling cold plate with sparse and dense fins. For different heat sources generating heat differently, fins with different densities are disposed in corresponding fluid channels corresponding to the heat sources to balance heat dissipation. The other is an independent fluid channel design. Fluid channels under different heat sources are independently designed to dissipate heat in different regions. However, the liquid cooling cold plate designed in the two design manners has a complex fluid channel design manner when there are a plurality of heat sources.

EP 3531234 A1 describes a circuit card assembly that includes a circuit card, a plurality of components disposed on a first surface of the circuit card in a shadow arrangement, and a plurality of air-cooled heat sink structures disposed on each of the components. CN 205944338 U concerns a liquid cooling coupling, liquid cooling pipe and liquid cooling device. From CN 110993576 A, a heat dissipation device is known.

### SUMMARY

This application provides a liquid cooling cold plate and a communications device according to the independent claims, to simplify a fluid channel design and improve a heat dissipation effect on an electronic component. Particular embodiments are defined by the dependent claims.

### BRIEF DESCRIPTION OF DRAWINGS

FIG. 1 is a schematic diagram of an application scenario of a liquid cooling cold plate according to an embodiment of this application;
FIG. 2 is a schematic diagram of heat dissipation regions corresponding to a liquid cooling cold plate according to an embodiment of this application;
FIG. 3 is a schematic exploded diagram of a liquid cooling cold plate according to a non-claimed embodiment of this application;
FIG. 4 is a schematic diagram of fluid channels of a liquid cooling cold plate according tc a non-claimed embodiment of this application;
FIG. 5 is a schematic structural diagram of a distribution module of a liquid cooling cold plate according to a non-claimed embodiment of this application;
FIG. 6 is another schematic structural diagram of a distribution module of a liquid cooling cold plate according to an embodiment of this application;
FIG. 7 is a schematic diagram when a liquid cooling cold plate corresponds to a plurality of heat dissipation regions according to an embodiment of this application; and
FIG. 8 is a schematic diagram of a baffle plate when a liquid cooling cold plate corresponds to a plurality of heat dissipation regions according to an embodiment of this application.

### DESCRIPTION OF EMBODIMENTS

To make the objectives, technical solutions, and advantages of this application clearer, the following further describes this application in detail with reference to the accompanying drawings.

First, an application scenario of a heat dissipation apparatus is described. The heat dissipation apparatus provided in the embodiments of this application is configured to dissipate heat for a high-power semiconductor component. With development of a current electronic device, the electronic device includes increasingly more high-power components, and has a higher requirement on the heat dissipation apparatus. In addition, because smaller space is left for a heat dissipation component as the current electronic device develops towards miniaturization and integration, a heat dissipation capability of the high-power semiconductor component in case of a high power density needs to be urgently improved. Therefore, the embodiments of this application provide a heat dissipation apparatus, configured to improve a heat dissipation effect on the high-power component in the electronic device.

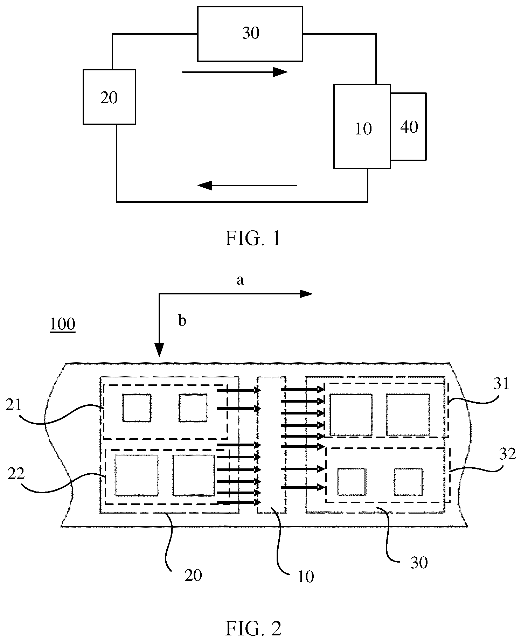

FIG. 1 illustrates an application scenario of a liquid cooling cold plate according to an embodiment of this application. A liquid cooling cold plate 10 provided in this embodiment of this application is configured to dissipate heat for a high-power semiconductor component 40. As shown in FIG. 1, the liquid cooling cold plate 10 is connected to an external heat dissipation system to form a heat dissipation loop. For example, the external heat dissipation system in FIG. 1 includes a pump 30 and a condenser 20. The pump 30 and the condenser 20 are connected to the liquid cooling cold plate 10 by using a pipeline, to form the heat dissipation loop. The heat dissipation loop is filled with fluid. Under an action of the pump 30, the fluid may flow in the heat dissipation loop. A direction shown by an arrow shown in FIG. 1 is a flow direction of the fluid. For ease of description, the flow direction of the fluid is defined as a first direction. The liquid cooling cold plate 10 is thermally conductively connected to the high-power semiconductor component 40. During heat dissipation, heat generated by the high-power semiconductor component 40 is transferred to the liquid cooling cold plate 10, and is transferred to fluid in the liquid cooling cold plate 10 by using the liquid cooling cold plate 10. Temperature of the fluid increases. The high-temperature fluid enters the condenser 20 under the action of the pump 30 to condense and cool down to form low-temperature fluid. The low-temperature fluid flows into the liquid cooling cold plate 10 again, so that the heat generated by the high-power semiconductor component 40 can be continuously removed.

The foregoing fluid may be kerosene, water, or another common fluid medium.

The foregoing high-power semiconductor component 40 may be different components such as a chip, an IGBT, or another common high-power semiconductor component. For ease of description, the high-power semiconductor component is briefly referred to as a component.

FIG. 2 is a schematic diagram of heat dissipation regions corresponding to a liquid cooling cold plate. For ease of description, a direction a is introduced, and the direction a is a flow direction of fluid in a liquid cooling cold plate 100. At least two heat dissipation regions are disposed on the liquid cooling cold plate 100, and the at least two heat dissipation regions are arranged in the flow direction of the fluid in the liquid cooling cold plate 100. FIG. 2 illustrates only two heat dissipation regions: a first heat dissipation region 20 and a second heat dissipation region 30. The first heat dissipation region 20 and the second heat dissipation region 30 are arranged in the direction a.

Each heat dissipation region of the first heat dissipation region 20 and the second heat dissipation region 30 includes at least two heat dissipation sub-regions arranged in a direction b. Powers of components in the heat dissipation sub-regions are different, that is, the components in the heat dissipation sub-regions generate heat differently, and therefore have different corresponding heat dissipation requirements. The first heat dissipation region 20 and the second heat dissipation region 30 are used as an example. The first heat dissipation region 20 includes a first heat dissipation sub-region 21 and a second heat dissipation sub-region 22 that are arranged in the direction b. Heat dissipation requirements of components in the first heat dissipation sub-region 21 and the second heat dissipation sub-region 22 are different. The component in the first heat dissipation sub-region 21 has a lower power, and has a lower heat dissipation requirement. The component in the second heat dissipation sub-region 22 has a higher power, and has a higher heat dissipation requirement. Therefore, a flow rate of fluid corresponding to the first heat dissipation sub-region 21 is less than a flow rate of fluid corresponding to the second heat dissipation sub-region 22. The second heat dissipation region 30 includes a third heat dissipation sub-region 31 and a fourth heat dissipation sub-region 32 that are arranged in the direction b. Heat dissipation requirements of components in the third heat dissipation sub-region 31 and the fourth heat dissipation sub-region 32 are different. The component in the third heat dissipation sub-region 31 has a lower power, and has a lower heat dissipation requirement. The component in the fourth heat dissipation sub-region 32 has a higher power, and has a higher heat dissipation requirement. Therefore, a flow rate of fluid corresponding to the third heat dissipation sub-region 31 is less than a flow rate of fluid corresponding to the fourth heat dissipation sub-region 32.

In an optional implementation solution, the heat dissipation region provided in this embodiment of this application may alternatively include different quantities of heat dissipation sub-regions, for example, three or four. For example, in the structure shown in FIG. 2, two adjacent heat dissipation regions may include a same quantity of heat dissipation sub-regions. Alternatively, two adjacent heat dissipation regions include different quantities of heat dissipation sub-regions, for example, one heat dissipation region includes three heat dissipation sub-regions, and the other heat dissipation region includes four heat dissipation sub-regions or two heat dissipation sub-regions.

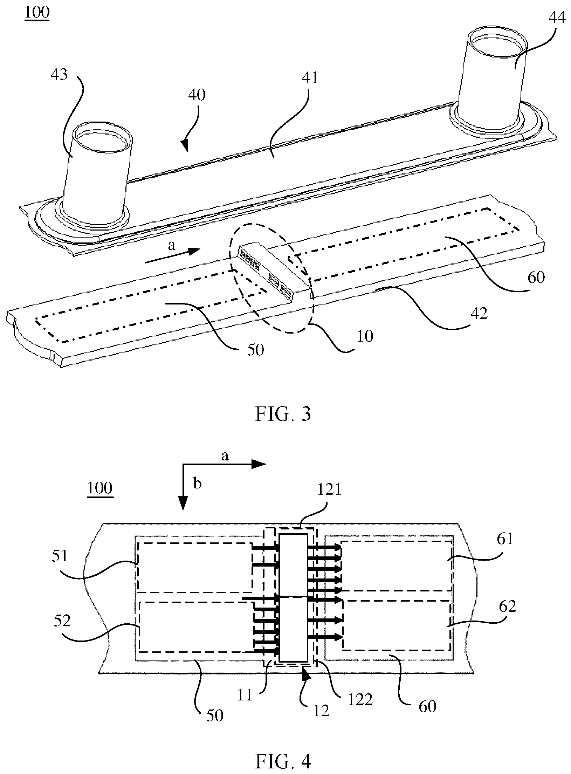

The two heat dissipation regions shown in FIG. 2 are used as an example to describe fluid flow of the liquid cooling cold plate 100 in this embodiment of this application. For ease of description, the fluid corresponding to the first heat dissipation sub-region 21 is first fluid, the fluid corresponding to the second heat dissipation sub-region 22 is second fluid, the fluid corresponding to the third heat dissipation sub-region 31 is third fluid, and the fluid corresponding to the fourth heat dissipation sub-region 32 is fourth fluid. As shown in FIG. 2, the first fluid and the third fluid are arranged in the direction a, and the second fluid and the fourth fluid are arranged in the direction a. To ensure that heat of the components in the first heat dissipation sub-region 21, the second heat dissipation sub-region 22, the third heat dissipation sub-region 31, and the fourth heat dissipation sub-region 32 can be well dissipated, a flow rate needs to be increased when the first fluid flows to the third fluid, and a flow rate needs to be decreased when the second fluid flows to the fourth fluid, to ensure heat dissipation effects on the components in the third heat dissipation sub-region 31 and the fourth heat dissipation sub-region 32. Because a total amount of fluid flowing through the first heat dissipation region 20 and the second heat dissipation region 30 does not change, the fluid needs to be re-allocated when flowing from the first heat dissipation region 20 to the second heat dissipation region 30. In this application, the fluid is re-allocated by using a re-allocation module 10 located between the first heat dissipation region 20 and the second heat dissipation region 30. A quantity of arrows shown in FIG. 2 represents a value of a flow rate, and the re-allocation module 10 is disposed between the first heat dissipation region 20 and the second heat dissipation region 30. After flowing through the first heat dissipation region 20, the fluid is re-allocated by using the re-allocation module 10, so that the fluid can meet a flow rate requirement of each heat dissipation sub-region in the second heat dissipation region 30 on the fluid. With reference to FIG. 3, the following describes in detail a structure and working of the re-allocation module 10 provided in this embodiment of this application.

FIG. 3 is a schematic exploded diagram of a liquid cooling cold plate according to an embodiment of this application. The liquid cooling cold plate 100 provided in this embodiment of this application includes a housing 40, and the housing 40 is configured to bear a component. The foregoing heat dissipation regions are all disposed on a surface of the housing 40, and a channel used for fluid flow is disposed in the housing 40. In addition, a liquid inlet 43 and a liquid outlet 44 that are connected to the fluid channel are disposed on the housing 40, and the liquid inlet 43 and the liquid outlet 44 may be connected to an external heat dissipation system by using a pipeline, to form a heat dissipation loop.

Referring to the direction a, the direction a points from the liquid inlet 43 to the liquid outlet 44, and fluid flows in the channel in the direction a from the liquid inlet 43 to the liquid outlet 44. The channel may be divided into a plurality of fluid channels in the direction a, and the plurality of fluid channels are in a one-to-one correspondence with the heat dissipation regions. When the fluid flows through each fluid channel, heat dissipation may be performed on a component disposed in a heat dissipation region corresponding to the fluid channel. When there are two heat dissipation regions, there are also two fluid channels. A fluid channel shown in FIG. 3 is used as an example. The fluid channel is divided into a first fluid channel 50 and a second fluid channel 60 in the direction a, and the re-allocation module 10 is disposed between the first fluid channel 50 and the second fluid channel 60. A length direction of the re-allocation module 10 is disposed in the direction b to separate the first fluid channel 50 and the second fluid channel 60. The first fluid channel 50 is a fluid channel located upstream of the re-allocation module 10, and corresponds to the first heat dissipation region. The second fluid channel 60 is a fluid channel located downstream of the re-allocation module 10, and corresponds to the second heat dissipation region.

In an optional solution, a detachable structure may be used for the housing 40. As shown in FIG. 3, the housing 40 includes a base plate 42 and an upper cover 41 covering the base plate 42. The upper cover 41 and the base plate 42 may be fixedly connected to each other through bonding or welding or by using a threaded connecting piece (a bolt or a screw). When the upper cover 41 and the base plate 42 are connected, the upper cover 41 and the base plate 42 are sealed, for example, sealed by using sealing glue. The liquid inlet 43 and the liquid outlet 44 are disposed on the upper cover 41, and the heat dissipation region is disposed on a surface that is of the base plate 42 and that is away from the upper cover 41. The re-allocation module 10 and the fluid channel in each heat dissipation region are located in a cavity surrounded by the upper cover 41 and the base plate 42. For example, the re-allocation module 10 is disposed on the base plate 42. When the upper cover 41 covers the base plate 42, the re-allocation module 10 may separate the first fluid channel 50 and the second fluid channel 60.

In an optional solution, the housing 40 may be integrally formed. The upper cover 41, the base plate 42, and the re-allocation module 10 shown in FIG. 3 may be integrally produced and formed in a manner such as injection molding or 3D printing.

During application, fluid in the upstream fluid channel (the first fluid channel 50) is converged by using the re-allocation module 10, and the converged fluid is distributed to the downstream fluid channel (the second fluid channel 60) by using the re-allocation module 10. As shown in FIG. 3, the fluid in the first fluid channel 50 may be converged by using the re-allocation module 10, and the converged fluid may be allocated by the re-allocation module 10 based on requirements of different regions in the second fluid channel 60.

During specific implementation, the re-allocation module has regions with different fluid resistance, and allocates the converged fluid to different regions in the downstream fluid channel based on a specified flow rate by using the regions with different fluid resistance. As shown in FIG. 4, the first fluid channel 50 and the second fluid channel 60 are used as an example for description. For an arrangement manner of the first heat dissipation region and the second heat dissipation region that correspond to the first fluid channel 50 and the second fluid channel 60 in FIG. 4 and a manner of included heat dissipation sub-regions, refer to related descriptions in FIG. 2. The first fluid channel 50 includes a first subchannel 51 and a second subchannel 52 that are arranged in the direction b, the first subchannel 51 corresponds to the first heat dissipation sub-region, and the second subchannel 52 corresponds to the second heat dissipation sub-region. The second fluid channel 60 includes a third subchannel 61 and a fourth subchannel 62 that are arranged in the direction b, the third subchannel 61 corresponds to the third heat dissipation sub-region, and the fourth subchannel 62 corresponds to the fourth heat dissipation sub-region. The first fluid corresponding to the first heat dissipation sub-region flows in the first subchannel 51, the second fluid corresponding to the second heat dissipation sub-region flows in the second subchannel 52, the third fluid corresponding to the third heat dissipation sub-region flows in the third subchannel 61, and the fourth fluid corresponding to the fourth heat dissipation sub-region flows in the fourth subchannel 62. The re-allocation module includes a first flow blocking region 121 and a second flow blocking region 122. The first flow blocking region 121 is located between the first subchannel 51 and the third subchannel 61, and the second flow blocking region 122 is located between the second subchannel 52 and the fourth subchannel 62. The first flow blocking region 121 and the second flow blocking region 122 have different fluid resistance. The foregoing fluid resistance is fluid resistance applied to fluid by the first flow blocking region 121 and the second flow blocking region 122. Larger fluid resistance indicates a smaller flow rate of the fluid.

Referring to the arrangement manner of the components in the heat dissipation sub-region in FIG. 2, to ensure that the fluid can dissipate heat for the components in the second heat dissipation region well, fluid resistance of the first flow blocking region 121 is less than fluid resistance of the second flow blocking region 122. An example in which a total flow rate of fluid is Q1 is used. A flow rate of the first fluid in the first subchannel 51 is Q2, and a flow rate of the second fluid in the second subchannel 52 is Q3. A total flow rate of fluid in the first fluid channel 50 is Q1=Q2+Q3, where Q2<Q3. After the fluid flowing through the first fluid channel 50 is converged by using the re-allocation module, a flow direction of the fluid is blocked by the first flow blocking region 121 and the second flow blocking region 122, and the fluid is converged by using the re-allocation module. After the fluid is allocated by the re-allocation module, a flow rate of the third fluid entering the third subchannel 61 by using the first flow blocking region 121 is Q4, and a flow rate of the fourth fluid entering the fourth subchannel 62 by using the second flow blocking region 122 is Q5. A total flow rate of fluid in the second fluid channel 60 is Q1=Q4+Q5, where Q3>Q5. It can be learned from the foregoing description that when fluid flows in the direction a, allocation of flow rates of the fluid in different subchannels of a fluid channel may be controlled by using the re-allocation module, so that a flow rate of corresponding allocated fluid can be properly adjusted in an actual component arrangement manner, thereby improving a heat dissipation effect on the component.

In an optional solution, the re-allocation module includes a convergence cavity 11 and a distribution module 12. The convergence cavity 11 is connected to the upstream fluid channel, and is configured to converge the fluid in the upstream fluid channel. The convergence cavity 11 is a region between the first fluid channel 50 and the distribution module 12. The region may be formed by disposing a wall structure that is connected to the distribution module 12 and that is on the base plate of the liquid cooling cold plate 100, or may be formed by using the housing of the liquid cooling cold plate 100. The fluid (the flow rate Q2) flowing through the first subchannel 51 and the fluid (the flow rate Q3) flowing through the second subchannel 52 are converged in the convergence cavity 11. The distribution module 12 is configured to form the first flow blocking region 121 and the second flow blocking region 122. Specifically, distribution channels disposed on the distribution module 12 are used for implementation. Different distribution channels are disposed in the first flow blocking region 121 and the second flow blocking region 122, to implement different fluid resistance. For example, a cross-flow area of a channel through which fluid can pass in the distribution channel disposed in the first flow blocking region 121 is A, and a cross-flow area of a channel through which fluid can pass in a distribution channel disposed in the second flow blocking region 122 is B. If A>B, the fluid resistance of the first flow blocking region 121 is less than the fluid resistance of the second flow blocking region 122. The foregoing distribution module 12 and the fluid channel may be implemented in different manners. The following is separately described with reference to the accompanying drawings.

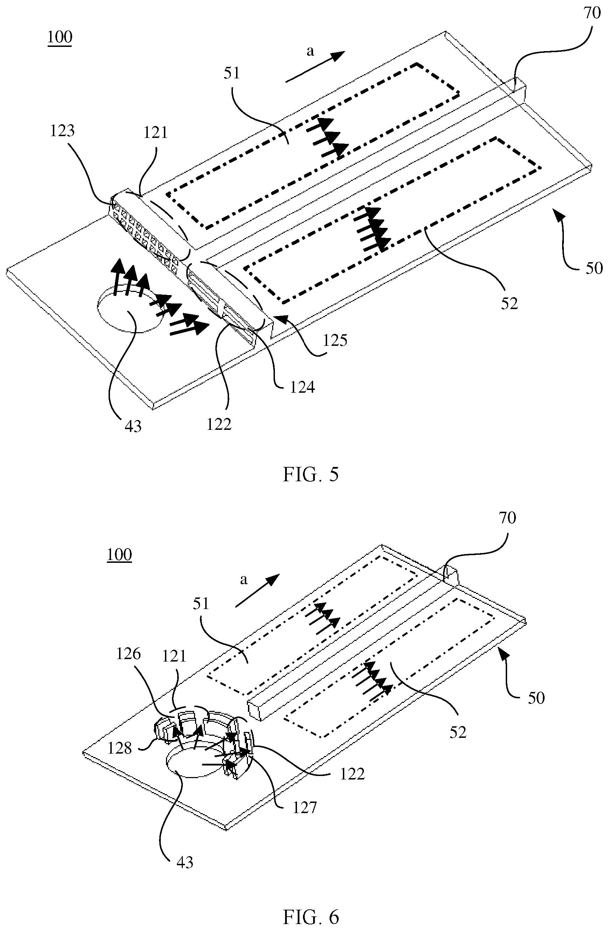

FIG. 5 shows a specific structure of a specific distribution module. In FIG. 5, the re-allocation module may be disposed between the liquid inlet 43 and the first fluid channel 50, and a principle thereof is the same as a principle of disposing the re-allocation module between the first fluid channel 50 and the second fluid channel. The distribution module includes a stopper 125. For example, the stopper 125 is a rectangular stopper, and a length direction of the stopper 125 is perpendicular to the flow direction of the fluid, to separate the liquid inlet 43 and the first fluid channel 50. A plurality of through holes are disposed on the stopper 125, and the plurality of through holes are distribution channels. The plurality of through holes are divided into first through holes 123 and second through holes 124. The first through holes 123 are disposed in the first flow blocking region 121, the second through holes 124 are disposed in the second flow blocking region 122, and pore sizes of through holes in different flow blocking regions are different. For example, two rows of first through holes 123 arranged into an array are disposed in the first flow blocking region 121, and two rows of second through holes 124 arranged into an array are disposed in the second flow blocking region 122. Both the first through hole 123 and the second through hole 124 are rectangular through holes, and an opening area of the first through hole 123 is less than an opening area of the second through hole 124. A total opening area of all the first through holes 123 in the first flow blocking region 121 is C, and a total opening area of the second through holes 124 in the second flow blocking region 122 is D, where C<D. When fluid flows through the distribution module, a flow rate flowing in the first subchannel 51 and a flow rate flowing in the second subchannel 52 meet: Q2<Q3.

In an optional implementation solution, the through holes provided in this embodiment of this application may be arranged in different quantities of rows, for example, a single row or three rows. This is not specifically limited in this application.

In an optional implementation solution, the through holes may be holes of different shapes, such as circular holes, rhombic holes, or elliptical holes that all may be applied to this embodiment of this application.

In an optional implementation solution, the opening area of the first through hole 123 and the opening area of the second through hole 124 may be the same. Different quantities of first through holes 123 and second through holes 124 may be disposed by using the first flow blocking region 121 and the second flow blocking region 122, to implement different fluid resistance of the first flow blocking region 121 and the second flow blocking region 122.

In an optional implementation solution, different shapes may be alternatively selected for the stopper 125, such as a V shape or an arc-shaped shape. However, regardless of which shape is selected, a concave direction of the stopper 125 faces the upstream fluid channel or the liquid inlet 43. A region surrounded by a concave surface of the stopper 125 may be used as the convergence cavity.

In an optional solution, the distribution module further includes a baffle plate 70, and the baffle plate 70 extends in the flow direction of the fluid and is configured to space any two adjacent heat dissipation sub-regions, so that the two adjacent heat dissipation sub-regions can be separated. That the adjacent heat dissipation sub-regions are separated means that the baffle plate 70 is located in the fluid channel and separates two subchannels corresponding to two heat dissipation sub-regions. As shown in FIG. 5, the first fluid channel 50 includes the first subchannel 51 and the second subchannel 52, and the first subchannel 51 and the second subchannel 52 are separated by using the baffle plate 70, to avoid interference caused by the fluid in the first subchannel 51 to the fluid in the second subchannel 52, thereby improving a heat dissipation effect of the fluid on the component.

In an optional solution, the stopper 125 and the baffle plate 70 may have an integral structure. During specific production, the stopper 125, the baffle plate 70, and the base plate may be integrally formed, for example, produced into an integral structure in a manner such as injection molding or 3D printing. Certainly, a detachable structure may be used. In this case, the stopper 125 may be connected to the base plate in different manners such as bonding, welding, or riveting, and the baffle plate 70 may be fixedly connected to the base plate in a same manner. It should be understood that, when a detachable structure is used for the stopper 125, the baffle plate 70, and the base plate, sealing may be performed by using sealing glue, to ensure that the stopper 125 and the baffle plate 70 can separate fluid.

In an optional solution, a plurality of heat dissipation fins (not shown in the figure) are disposed in each fluid channel, the plurality of heat dissipation fins are arranged into an array in the flow direction of the fluid, and a channel for fluid flow is left between the heat dissipation fins. When the fluid flows through the heat dissipation fins, the fluid can absorb heat transferred by the component to the heat dissipation fins, thereby improving a heat dissipation effect on the component.

FIG. 6 is another schematic structural diagram of a distribution module. In FIG. 6, the re-allocation module may be disposed between the liquid inlet 43 and the first fluid channel 50, and a principle thereof is the same as a principle of disposing the re-allocation module between the first fluid channel 50 and the second fluid channel. The distribution module includes a plurality of distribution plates 128. The plurality of distribution plates 128 are disposed around the liquid inlet 43, and the convergence cavity is surrounded by the plurality of distribution plates 128. In addition, the plurality of distribution plates 128 are spaced from each other by gaps, and the gaps are distribution channels. For ease of description, a plurality of gaps are divided into first gaps 126 and second gaps 127. The first gaps 126 are disposed in the first flow blocking region 121, the second gaps 127 are disposed in the second flow blocking region 122, and gaps in different flow blocking regions have different sizes. For example, an opening area of the first gap 126 is less than an opening area of the second gap 127. A total opening area of all first gaps 126 in the first region is E, and a total opening area of second gaps 127 in the second flow blocking region 122 is F, where E<F. When fluid flows through the distribution module. a flow rate flowing in the first subchannel and a flow rate flowing in the second subchannel meet: Q2<Q3.

In an optional implementation solution, the opening area of the first gap 126 and the opening area of the second gap 127 may be the same. Different quantities of first gaps 126 and second gaps 127 may be disposed by using the first flow blocking region 121 and the second flow blocking region 122, to implement different fluid resistance of the first flow blocking region 121 and the second flow blocking region 122.

In an optional solution, the distribution plates 128 are arc-shaped distribution plates, and a semi-cylindrical convergence cavity is surrounded by the distribution plates 128, and an opening direction of the convergence cavity faces the upstream fluid channel. After fluid flowing through the liquid inlet 43 is converged by using the convergence cavity, the fluid is re-allocated by using the distribution plates 128.

In an optional solution, the distribution plates 128 are arranged into two layers. As shown in FIG. 6, the distribution plates 128 are arranged into two layers in a direction away from the liquid inlet 43. Certainly, the distribution plates 128 may be arranged into a plurality of different quantities of layers, for example, one layer or three layers.

In an optional solution, the distribution module further includes a baffle plate 70, and the baffle plate 70 extends in the flow direction of the fluid and is configured to space any two adjacent heat dissipation sub-regions, so that the two adjacent heat dissipation sub-regions can be separated. That the adjacent heat dissipation sub-regions are separated means that the baffle plate 70 is located in the fluid channel and separates two subchannels corresponding to two heat dissipation sub-regions. As shown in FIG. 5, the first fluid channel 50 includes the first subchannel 51 and the second subchannel 52, and the first subchannel 51 and the second subchannel 52 are separated by using the baffle plate 70, to avoid interference caused by the fluid in the first subchannel 51 to the fluid in the second subchannel 52, thereby improving a heat dissipation effect of the fluid on the component.

In an optional solution, the distribution plates 128 and the baffle plate 70 have a detachable structure. During specific production, the distribution plates 128 and the base plate, and the baffle plate 70 and the base plate may be integrally formed, for example, produced into an integral structure in a manner such as injection molding or 3D printing. Certainly, a detachable structure may be used. In this case, the distribution plates 128 may be connected to the base plate in different manners such as bonding, welding, or riveting, and the baffle plate 70 may be fixedly connected to the base plate in a same manner. It should be understood that, when a detachable structure is used for the distribution plates 128, the baffle plate 70, and the base plate, sealing may be performed by using sealing glue, to ensure that the distribution plates 128 and the baffle plate 70 can separate fluid.

In an optional solution, a plurality of heat dissipation fins (not shown in the figure) are disposed in each fluid channel, the plurality of heat dissipation fins are arranged into an array in the flow direction of the fluid, and a channel for fluid flow is left between the heat dissipation fins. When the fluid flows through the heat dissipation fins, the fluid can absorb heat transferred by the component to the heat dissipation fins, thereby improving a heat dissipation effect on the component. During specific production, the heat dissipation fins may be produced on the base plate through integral production, or may be fastened to the base plate in a manner such as bonding, welding, or riveting.

It may be learned from the foregoing description that the liquid cooling cold plate 100 provided in this embodiment of this application can meet heat dissipation requirements of component arrangement of different heat dissipation requirements. When heat dissipation requirements of heat sources disposed in heat dissipation regions are different, the fluid in the upstream fluid channel is converged by using the re-allocation module, and the entire converged fluid is re-allocated to a downstream heat dissipation region. Circulation of distribution-convergence-distribution is set for the entire fluid, so that corresponding flow rates can be provided to regions with different heat dissipation requirements in the downstream heat dissipation region. In addition, a fluid channel setting is simplified, so that different flow rates can be allocated between the upstream and downstream fluid channels, thereby improving a heat dissipation effect.

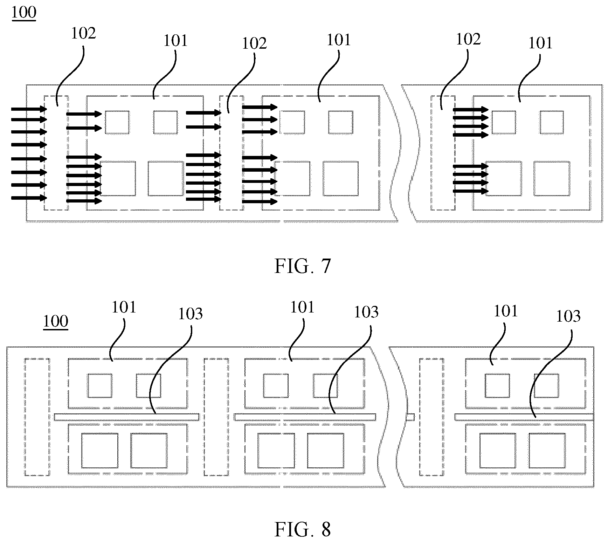

As an expansion solution, as shown in FIG. 7, the liquid cooling cold plate provided in this embodiment of this application may include a plurality of different quantities of heat dissipation regions 101, for example, three or four. A plurality of heat dissipation regions 101 are also arranged in a single row in the direction a. When a re-allocation module 102 is disposed, the re-allocation module 102 may be disposed between any adjacent heat dissipation regions 101, or the re-allocation module 102 may be disposed only between some adjacent heat dissipation regions 101. Alternatively, the re-allocation module 102 is disposed between the liquid inlet and an adjacent heat dissipation region 101. In any one of the foregoing cases, a heat dissipation effect of the liquid cooling cold plate 100 can be improved.

As shown in FIG. 8, when a plurality of heat dissipation regions 101 are used, a baffle plate 103 may be disposed in any fluid channel, or a baffle plate 103 may be disposed in some fluid channels.

When a plurality of heat dissipation regions 101 are used, heat dissipation fins may be disposed in each fluid channel, or heat dissipation fins may be disposed only in some fluid channels.

An embodiment of this application provides a communications device, and the communications device may be different communications devices such as a cabinet and a base station. The communications device includes the liquid cooling cold plate in any one of the foregoing implementations and an electronic component disposed in each heat dissipation region. Fluid in an upstream fluid channel is converged by using a re-allocation module, and the entire converged fluid is re-allocated to a downstream heat dissipation region, so that corresponding flow rates can be provided to regions with different heat dissipation requirements in the downstream heat dissipation region.

The protection scope of this application shall be subject to the protection scope of the claims. to two heat dissipation sub-regions. As shown in FIG. 5, the first fluid channel 50 includes the first subchannel 51 and the second subchannel 52, and the first subchannel 51 and the second subchannel 52 are separated by using the baffle plate 70, to avoid interference caused by the fluid in the first subchannel 51 to the fluid in the second subchannel 52, thereby improving a heat dissipation effect of the fluid on the component.

In an optional solution, the distribution plates 128 and the baffle plate 70 have a detachable structure. During specific production, the distribution plates 128 and the base plate, and the baffle plate 70 and the base plate may be integrally formed, for example, produced into an integral structure in a manner such as injection molding or 3D printing. Certainly, a detachable structure may be used. In this case, the distribution plates 128 may be connected to the base plate in different manners such as bonding, welding, or riveting, and the baffle plate 70 may be fixedly connected to the base plate in a same manner. It should be understood that, when a detachable structure is used for the distribution plates 128, the baffle plate 70, and the base plate, sealing may be performed by using sealing glue, to ensure that the distribution plates 128 and the baffle plate 70 can separate fluid.

In an optional solution, a plurality of heat dissipation fins (not shown in the figure) are disposed in each fluid channel, the plurality of heat dissipation fins are arranged into an array in the flow direction of the fluid, and a channel for fluid flow is left between the heat dissipation fins. When the fluid flows through the heat dissipation fins, the fluid can absorb heat transferred by the component to the heat dissipation fins, thereby improving a heat dissipation effect on the component. During specific production, the heat dissipation fins may be produced on the base plate through integral production, or may be fastened to the base plate in a manner such as bonding, welding, or riveting.

It may be learned from the foregoing description that the liquid cooling cold plate 100 provided in this embodiment of this application can meet heat dissipation requirements of component arrangement of different heat dissipation requirements. When heat dissipation requirements of heat sources disposed in heat dissipation regions are different, the fluid in the upstream fluid channel is converged by using the re-allocation module, and the entire converged fluid is re-allocated to a downstream heat dissipation region. Circulation of distribution-convergence-distribution is set for the entire fluid, so that corresponding flow rates can be provided to regions with different heat dissipation requirements in the downstream heat dissipation region. In addition, a fluid channel setting is simplified, so that different flow rates can be allocated between the upstream and downstream fluid channels, thereby improving a heat dissipation effect.

As an expansion solution, as shown in FIG. 7, the liquid cooling cold plate provided in this embodiment of this application may include a plurality of different quantities of heat dissipation regions 101, for example, three or four. A plurality of heat dissipation regions 101 are also arranged in a single row in the direction a. When a re-allocation module 102 is disposed, the re-allocation module 102 may be disposed between any adjacent heat dissipation regions 101, or the re-allocation module 102 may be disposed only between some adjacent heat dissipation regions 101. Alternatively, the re-allocation module 102 is disposed between the liquid inlet and an adjacent heat dissipation region 101. In any one of the foregoing cases, a heat dissipation effect of the liquid cooling cold plate 100 can be improved.

As shown in FIG. 8, when a plurality of heat dissipation regions 101 are used, a baffle plate 103 may be disposed in any fluid channel, or a baffle plate 103 may be disposed in some fluid channels.

When a plurality of heat dissipation regions 101 are used, heat dissipation fins may be disposed in each fluid channel, or heat dissipation fins may be disposed only in some fluid channels.

An embodiment of this application provides a communications device, and the communications device may be different communications devices such as a cabinet and a base station. The communications device includes the liquid cooling cold plate in any one of the foregoing implementations and an electronic component disposed in each heat dissipation region. Fluid in an upstream fluid channel is converged by using a re-allocation module, and the entire converged fluid is re-allocated to a downstream heat dissipation region, so that corresponding flow rates can be provided to regions with different heat dissipation requirements in the downstream heat dissipation region.

Further embodiments of the present invention are provided in the following. It should be noted that the numbering used in the following section does not necessarily need to comply with the numbering used in the previous sections.
Embodiment 1. A liquid cooling cold plate, comprising a housing and at least two heat dissipation regions arranged on the housing in a flow direction of fluid, wherein a fluid channel corresponding to each heat dissipation region is disposed in the housing, and a re-allocation module is disposed between at least two adjacent fluid channels; and fluid in a fluid channel located upstream of the re-allocation module is converged by using the re-allocation module, and the converged fluid is distributed to a downstream fluid channel by using the re-allocation module.
Embodiment 2. The liquid cooling cold plate according to embodiment 1, wherein the re-allocation module has regions with different fluid resistance, and allocates the converged fluid to different regions in the downstream fluid channel based on a specified flow rate by using the regions with different fluid resistance.
Embodiment 3. The liquid cooling cold plate according to embodiment 1 or 2, wherein the re-allocation module comprises a convergence cavity and a distribution module, wherein the convergence cavity is connected to the upstream fluid channel, and is configured to converge the fluid in the upstream fluid channel; and distribution channels are disposed on the distribution module, and the distribution channels are separately connected to the convergence cavity and the downstream fluid channel.
Embodiment 4. The liquid cooling cold plate according to embodiment 3, wherein the distribution module comprises a plurality of distribution plates, the convergence cavity is surrounded by the distribution plates, the plurality of distribution plates are spaced from each other by gaps, and the gaps are the distribution channels.
Embodiment 5. The liquid cooling cold plate according to embodiment 3, wherein the distribution module comprises a stopper 125, a plurality of through holes are disposed on the stopper 125, and the plurality of through holes are the distribution channels.
Embodiment 6. The liquid cooling cold plate according to embodiment 5, wherein the stopper is a rectangular stopper, and a length direction of the stopper is perpendicular to the flow direction of the fluid.
Embodiment 7. The liquid cooling cold plate according to any one of embodiments 3 to 6, wherein at least two heat dissipation sub-regions that have different heat dissipation requirements are disposed in a downstream heat dissipation region; and
   the distribution module further comprises a baffle plate, and the baffle plate extends in the flow direction of the fluid and is configured to space any two adjacent heat dissipation sub-regions.
Embodiment 8. The liquid cooling cold plate according to embodiment 6, wherein when the distribution module comprises the stopper, the stopper and the baffle plate have an integral structure.
Embodiment 9. The liquid cooling cold plate according to any one of embodiments 1 to 8, wherein a plurality of heat dissipation fins are disposed in each fluid channel.
Embodiment 10. The liquid cooling cold plate according to any one of embodiments 1 to 9, wherein the housing comprises a base plate and an upper cover covering the base plate, and the re-allocation module and the fluid channel in each heat dissipation region are located in a cavity surrounded by the upper cover and the base plate.
Embodiment 11. A communications device, comprising the liquid cooling cold plate according to any one of embodiments 1 to 10 and an electronic component disposed in each heat dissipation region. The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A liquid cooling cold plate (100), comprising a housing (40), a liquid inlet (43) and a liquid outlet (44) disposed on the housing (40) that are connected to a first fluid channel (50) disposed in the housing (40) for fluid flow from the liquid inlet (43) to the liquid outlet (44), wherein the first fluid channel (50) is separated into a first subchannel (51) and a second subchannel (52) that are arranged in a direction perpendicular to the flow direction of the fluid;
**characterized in that**:
the liquid cooling cold plate (100) further comprises a distribution module (12),
wherein the distribution module (12) includes a plurality of distribution plates (128) disposed around the liquid inlet (43) wherein the plurality of distribution plates (128) are spaced from each other by gaps (126, 127) disposed in different flow blocking regions (121, 122) including a first flow blocking region (121) and a second flow blocking region (122) , wherein a total opening area of the gaps (126) in the first flow blocking region (121) is E, and a total opening area of the gaps (127) in the second flow blocking region (122) is F, where E<F.

2. The liquid cooling cold plate (100) according to claim 1, opening area of each the gap (126) in the first flow blocking region (121) and the opening area of the gap (127) in the second flow blocking region (122) are the same, quantities of the gaps (126) in the first flow blocking region (121) and quantities of the gaps (127) in the second flow blocking region (122) are different.

3. The liquid cooling cold plate (100) according to any one of claims 1-2, wherein the distribution plates (128) are arranged into a plurality of layers in a direction away from the liquid inlet (43).

4. The liquid cooling cold plate (100) according to any one of claims 1-3, wherein the distribution plates (128) are arc-shaped distribution plates, and a semi-cylindrical convergence cavity is surrounded by the distribution plates (128).

5. The liquid cooling cold plate (100) according to claim 4, wherein the convergence cavity is configured to converge, after fluid flowing through the liquid inlet (43), the fluid, and the distribution plates (128) are configured to re-allocate the fluid.

6. The liquid cooling cold plate (100) according to any one of claims 1-5, wherein the housing (40) includes a base plate (42) and an upper cover (41) covering the base plate (42), wherein the liquid inlet (43) and the liquid outlet (44) are disposed on the upper cover (41).

7. The liquid cooling cold plate (100) according to claim 6, wherein the distribution module (12) further includes a baffle plate (70) to separate the first fluid channel (50) into the first subchannel (51) and the second subchannel (52).

8. The liquid cooling cold plate (100) according to claim 7, wherein the baffle plate (70) extends in the flow direction of the fluid.

9. The liquid cooling cold plate (100) according to claims 7 or 8, wherein the distribution plates (128) and the baffle plate (70) are integrally formed with the base plate (42).

10. The liquid cooling cold plate (100) according to claim 6, a heat dissipation region (20) is disposed on a surface that is of the base plate (42) and that is away from the upper cover (41).

11. The liquid cooling cold plate (100) according to claim 10, wherein the heat dissipation region (20) includes a first heat dissipation sub-region (21) and a second heat dissipation sub-region (22) that are arranged in the direction perpendicular to the flow direction of the fluid.

12. The liquid cooling cold plate (100) according to claim 11, wherein the first subchannel (51) is corresponding to the first heat dissipation sub-region (21), the second subchannel (52) is corresponding to the second heat dissipation sub-region (22).

13. The liquid cooling cold plate (100) according to claim 12, wherein a flow rate of fluid in the first subchannel (51) corresponding to the first heat dissipation sub-region (21) is less than a flow rate of fluid in the second subchannel (52) corresponding to the second heat dissipation sub-region (22).

14. The liquid cooling cold plate (100) according to claim **11,** wherein components in the first heat dissipation sub-region (21) has a lower power and has a lower heat dissipation requirement, components in the second heat dissipation sub-region (22) has a higher power and has a higher heat dissipation requirement.

15. A communications device, comprising the liquid cooling cold plate (100) according to any one of claims 1 to **14** and an component disposed in each of the first heat dissipation sub-region (21) and the second heat dissipation sub-region (22).

## Patentansprüche

1. Flüssigkeitsgekühlte Kühlplatte (100), umfassend ein Gehäuse (40), einen am Gehäuse (40) angeordneten Flüssigkeitseinlass (43) und einen Flüssigkeitsauslass (44), die mit einem im Gehäuse (40) angeordneten ersten Fluidkanal (50) verbunden sind, um einen Fluidstrom vom Flüssigkeitseinlass (43) zum Flüssigkeitsauslass (44) zu ermöglichen, wobei der erste Fluidkanal (50) in einen ersten Teilkanal (51) und einen zweiten Teilkanal (52) unterteilt ist, die in einer zur Strömungsrichtung des Fluids rechtwinkligen Richtung angeordnet sind;
**dadurch gekennzeichnet, dass**:
die flüssigkeitsgekühlte Kühlplatte (100) ferner ein Verteilmodul (12) umfasst,
wobei das Verteilmodul (12) eine Vielzahl von Verteilplatten (128) umfasst, die um den Flüssigkeitseinlass (43) herum angeordnet sind, wobei die Vielzahl von Verteilplatten (128) durch Zwischenräume (126, 127) voneinander beabstandet sind, die in unterschiedlichen Strömungssperrbereichen (121, 122) angeordnet sind, einschließlich eines ersten Strömungssperrbereichs (121) und eines zweiten Strömungssperrbereichs (122), wobei eine Gesamtöffnungsfläche der Zwischenräume (126) im ersten Strömungssperrbereich (121) E ist und eine Gesamtöffnungsfläche der Zwischenräume (127) im zweiten Strömungssperrbereich (122) F ist, wobei E<F.

2. Flüssigkeitsgekühlte Kühlplatte (100) nach Anspruch 1, wobei die Öffnungsfläche jedes Zwischenraums (126) im ersten Strömungssperrbereich (121) und die Öffnungsfläche des Zwischenraums (127) im zweiten Strömungssperrbereich (122) gleich sind, und die Anzahl der Zwischenräume (126) im ersten Strömungssperrbereich (121) und die Anzahl der Zwischenräume (127) im zweiten Strömungssperrbereich (122) unterschiedlich sind.

3. Flüssigkeitsgekühlte Kühlplatte (100) nach einem der Ansprüche 1 bis 2, wobei die Verteilplatten (128) in einer vom Flüssigkeitseinlass (43) weggerichteten Richtung in einer Vielzahl von Schichten angeordnet sind.

4. Flüssigkeitsgekühlte Kühlplatte (100) nach einem der Ansprüche 1 bis 3, wobei die Verteilplatten (128) bogenförmige Verteilplatten sind und (128) ein halbzylindrischer Konvergenzhohlraum durch die Verteilplatten umschlossen ist.

5. Flüssigkeitsgekühlte Kühlplatte (100) nach Anspruch 4, wobei der Konvergenzhohlraum dazu ausgelegt ist, nach Durchströmen des Flüssigkeitseinlasses (43) die Flüssigkeit zusammenzuführen, und wobei die Verteilplatten (128) dazu ausgelegt sind, die Flüssigkeit neu aufzuteilen.

6. Flüssigkeitsgekühlte Kühlplatte (100) nach einem der Ansprüche 1 bis 5, wobei das Gehäuse (40) eine Grundplatte (42) und eine die Grundplatte (42) abdeckende obere Abdeckung (41) umfasst, wobei der Flüssigkeitseinlass (43) und der Flüssigkeitsauslass (44) an der oberen Abdeckung (41) angeordnet sind.

7. Flüssigkeitsgekühlte Kühlplatte (100) nach Anspruch 6, wobei das Verteilmodul (12) ferner eine Trennplatte (70) umfasst, um den ersten Fluidkanal (50) in den ersten Teilkanal (51) und den zweiten Teilkanal (52) zu unterteilen.

8. Flüssigkeitsgekühlte Kühlplatte (100) nach Anspruch 7, wobei sich die Trennplatte (70) in Strömungsrichtung der Flüssigkeit erstreckt.

9. Flüssigkeitsgekühlte Kühlplatte (100) nach Anspruch 7 oder 8, wobei die Verteilplatten (128) und die Trennplatte (70) einstückig mit der Grundplatte (42) ausgebildet sind.

10. Flüssigkeitsgekühlte Kühlplatte (100) nach Anspruch 6, wobei auf einer der oberen Abdeckung (41) abgewandten Oberfläche der Grundplatte (42) ein Wärmeableitbereich (20) angeordnet ist.

11. Flüssigkeitsgekühlte Kühlplatte (100) nach Anspruch 10, wobei der Wärmeableitbereich (20) einen ersten Wärmeableit-Teilbereich (21) und einen zweiten Wärmeableit-Teilbereich (22) umfasst, die in der zur Strömungsrichtung der Flüssigkeit rechtwinkligen Richtung angeordnet sind.

12. Flüssigkeitsgekühlte Kühlplatte (100) nach Anspruch 11, wobei der erste Teilkanal (51) dem ersten Wärmeableit-Teilbereich (21) entspricht und der zweite Teilkanal (52) dem zweiten Wärmeableit-Teilbereich (22) entspricht.

13. Flüssigkeitsgekühlte Kühlplatte (100) nach Anspruch 12, wobei eine Durchflussrate der Flüssigkeit im ersten Teilkanal (51), der dem ersten Wärmeableit-Teilbereich (21) entspricht, kleiner als die Durchflussrate der Flüssigkeit im zweiten Teilkanal (52) ist, der dem zweiten Wärmeableit-Teilbereich (22) entspricht.

14. Flüssigkeitsgekühlte Kühlplatte (100) nach Anspruch 11, wobei Bauelemente im ersten Wärmeableit-Teilbereich (21) eine geringere Leistung aufweisen und einen geringeren Wärmeableitbedarf haben und Bauelemente im zweiten Wärmeableit-Teilbereich (22) eine höhere Leistung aufweisen und einen höheren Wärmeableitbedarf haben.

15. Kommunikationsvorrichtung, umfassend die flüssigkeitsgekühlte Kühlplatte (100) nach einem der Ansprüche 1 bis 14 und ein jeweils in dem ersten Wärmeableit-Teilbereich (21) und in dem zweiten Wärmeableit-Teilbereich (22) angeordnetes Bauelement.

## Revendications

1. Plaque froide de refroidissement par liquide (100), comprenant un boîtier (40), une entrée de liquide (43) et une sortie de liquide (44) disposées sur le boîtier (40) qui sont reliées à un premier canal de fluide (50) disposé dans le boîtier (40) pour permettre un écoulement de fluide de l'entrée de liquide (43) vers la sortie de liquide (44), le premier canal de fluide (50) étant séparé en un premier sous-canal (51) et un second sous-canal (52) qui sont agencés dans une direction perpendiculaire à la direction d'écoulement du fluide ;
**caractérisée en ce que** :
la plaque froide de refroidissement par liquide (100) comprend en outre un module de distribution (12),
le module de distribution (12) comprenant une pluralité de plaques de distribution (128) disposées autour de l'entrée de liquide (43), la pluralité de plaques de distribution (128) étant espacées les unes des autres par des espaces (126, 127) disposés dans différentes régions de blocage d'écoulement (121, 122) comprenant une première région de blocage d'écoulement (121) et une seconde région de blocage d'écoulement (122), une surface d'ouverture totale des espaces (126) dans la première région de blocage d'écoulement (121) étant E, et une surface d'ouverture totale des espaces (127) dans la seconde région de blocage d'écoulement (122) étant F, E<F.

2. Plaque froide de refroidissement par liquide (100) selon la revendication 1, la surface d'ouverture de chacun des espaces (126) dans la première région de blocage d'écoulement (121) et la surface d'ouverture de l'espace (127) dans la seconde région de blocage d'écoulement (122) étant identiques, le nombre d'espaces (126) dans la première région de blocage d'écoulement (121) et le nombre d'espaces (127) dans la seconde région de blocage d'écoulement (122) étant différents.

3. Plaque froide de refroidissement par liquide (100) selon l'une quelconque des revendications 1 et 2, les plaques de distribution (128) étant agencées en une pluralité de couches dans une direction opposée à l'entrée de liquide (43).

4. Plaque froide de refroidissement par liquide (100) selon l'une quelconque des revendications 1 à 3, les plaques de distribution (128) étant des plaques de distribution en forme d'arc, et une cavité de convergence semi-cylindrique étant entourée par les plaques de distribution (128).

5. Plaque froide de refroidissement par liquide (100) selon la revendication 4, la cavité de convergence étant configurée pour faire converger le fluide après que celui-ci s'est écoulé par l'entrée de liquide (43), et les plaques de distribution (128) étant configurées pour répartir à nouveau le fluide.

6. Plaque froide de refroidissement par liquide (100) selon l'une quelconque des revendications 1 à 5, le boîtier (40) comprenant une plaque de base (42) et un couvercle supérieur (41) recouvrant la plaque de base (42), l'entrée de liquide (43) et la sortie de liquide (44) étant disposées sur le couvercle supérieur (41).

7. Plaque froide de refroidissement par liquide (100) selon la revendication 6, le module de distribution (12) comprenant en outre une plaque déflectrice (70) pour séparer le premier canal de fluide (50) en le premier sous-canal (51) et le second sous-canal (52).

8. Plaque froide de refroidissement par liquide (100) selon la revendication 7, la plaque déflectrice (70) s'étendant dans la direction d'écoulement du fluide.

9. Plaque froide de refroidissement par liquide (100) selon les revendications 7 ou 8, les plaques de distribution (128) et la plaque déflectrice (70) étant formées d'un seul bloc avec la plaque de base (42).

10. Plaque froide de refroidissement par liquide (100) selon la revendication 6, une région de dissipation de chaleur (20) étant disposée sur une surface de la plaque de base (42) qui est opposée au couvercle supérieur (41).

11. Plaque froide de refroidissement par liquide (100) selon la revendication 10, la région de dissipation de chaleur (20) comprenant une première sous-région de dissipation de chaleur (21) et une seconde sous-région de dissipation de chaleur (22) qui sont agencées dans la direction perpendiculaire à la direction d'écoulement du fluide.

12. Plaque froide de refroidissement par liquide (100) selon la revendication 11, le premier sous-canal (51) correspondant à la première sous-région de dissipation de chaleur (21), le second sous-canal (52) correspondant à la seconde sous-région de dissipation de chaleur (22).

13. Plaque froide de refroidissement par liquide (100) selon la revendication 12, un débit du fluide dans le premier sous-canal (51) qui correspond à la première sous-région de dissipation de chaleur (21) étant inférieur à un débit du fluide dans le second sous-canal (52) qui correspond à la seconde sous-région de dissipation de chaleur (22).

14. Plaque froide de refroidissement par liquide (100) selon la revendication 11, les composants dans la première sous-région de dissipation de chaleur (21) présentant une puissance inférieure et des besoins de dissipation de chaleur inférieurs, les composants dans la seconde sous-région de dissipation de chaleur (22) présentant une puissance supérieure et des besoins de dissipation de chaleur supérieurs.

15. Dispositif de communication, comprenant la plaque froide de refroidissement par liquide (100) selon l'une quelconque des revendications 1 à 14 et un composant disposé dans chacune de la première sous-région de dissipation de chaleur (21) et de la seconde sous-région de dissipation de chaleur (22).
